Europäisches Patentamt

European Patent Office

Office européen des brevets

(11) Veröffentlichungsnummer: **0 142 083**

**A2**

(12) ## EUROPÄISCHE PATENTANMELDUNG

(21) Anmeldenummer: 84112870.5

(22) Anmeldetag: 25.10.84

(51) Int. Cl.⁴: **C 23 C 14/32**
//C23C14/56

(30) Priorität: 11.11.83 DE 3340840

(43) Veröffentlichungstag der Anmeldung:
22.05.85 Patentblatt 85/21

(84) Benannte Vertragsstaaten:
AT BE CH DE FR GB IT LI LU NL SE

(71) Anmelder: Hoesch Aktiengesellschaft
Eberhardstrasse 12
D-4600 Dortmund 1(DE)

(72) Erfinder: Diener, Arnulf, Dr.
Fürstenbergweg 15
D-4600 Dortmund 1(DE)

(72) Erfinder: Kettler, Hans, Dr.
Dörner Strasse 21
D-5348 Wissen/Sieg(DE)

(72) Erfinder: Tenhaven, Ulrich, Dr.
Kleiner Floraweg 22
D-4600 Dortmund 50(DE)

(54) **Verfahren und Einrichtung zum Herstellen metallischer Überzüge.**

(57) Verfahren zum kontinuierlichen Herstellen hochwertiger metallischer Überzüge auf Stahlband unter Verwendung eines Plasmas. Um bei einem solchen Verfahren auf ein schnell laufendes Stahlband kontinuierlich eine beidseitige hochwertige Beschichtung in einfacher Weise aufbringen zu können, wobei auch bei verhältnismäßig breiten Stahlbändern, bevorzugterweise mit einer Breite von mehr als 1.000 mm, eine enge Schichtdickentoleranz sowohl über die Bandlänge als auch über die Bandbreite erzielt werden soll und das Verfahren insgesamt durchzuführen ist, schlägt die Erfindung vor, daß ein oder mehrere Metalle oder Metallegierungen in einem ersten Schritt in einem thermischen Plasma aus nicht oxidierendem Gas kontinuierlich verdampft und selbst in den hoch ionisierten Zustand des thermischen Plasmas überführt werden und in einem zweiten Schritt bei einem gegenüber dem Außendruck um 100 Pa bis 5.000 Pa erhöhten Druck die in diesem Plasma vorhandenen Metallionen elektrostatisch auf der Oberfläche des Stahlbandes abgeschieden werden, das Stahlband während des Beschichtens auf einer gleichmäßigen Temperatur gehalten und bei einer Geschwindigkeit von 40 m/min bis 600 m/min beschichtet wird, wobei der erste Schritt, nämlich die Überführung des Metalls oder der Metallegierung in den hoch ionisierten Zustand und der zweite Schritt, nämlich das Abscheiden der Metallionen, örtlich getrennt nacheinander durchgefüht werden.

FIG. 1

Hoesch Aktiengesellschaft

Eberhardstraße 12, 4600 Dortmund 1

Verfahren und Einrichtung zum Herstellen metallischer Überzüge

Die Erfindung betrifft ein Verfahren zum kontinuierlichen Herstellen hochwertiger metallischer Überzüge auf Stahlband unter Verwendung eines Plasmas sowie eine Einrichtung zur Durchführung des Verfahrens.

Neben der Beschichtung von einzelnen Werkstücken hat die Beschichtung von kaltgewalztem Stahlband mit Aluminium technische Bedeutung erlangt und wird zur Herstellung von Verpackungsband angewandt. Hierbei wird Aluminium im Hochvakuum von $10^{-4}$ Torr durch Elektronenstrahlbündel bei 1.400° C verdampft. Über den Aluminium-Tiegel wird das kalte Stahlband geführt und der Aluminiumdampf kondensiert auf der kälteren Stahloberfläche. Die Schichtdicke des Niederschlages ist der Bedampfungszeit proportional, vgl. "Herstellung von kaltgewalztem Band", Teil 2, Verlag Stahleisen mbH, Düsseldorf, 1970, S. 231. Nachteilig bei diesem bekannten Verfahren ist, daß der Abdampfkegel, abhängig vom Brennfleck des Elektronenstahls und der freien Weglänge der Aluminiumatome, auf die Bandbreite abgestimmt sein muß. Ferner kann die Kondensationswärme des Aluminiums nur durch Abstrahlung und Aufnahme durch das Stahlband abgeführt werden. Um daher eine Legierungsbildung zwischen Aluminium und Stahlband zu $Fe_2Al_5$ bzw. $FeAl_3$ zu vermeiden, muß die Dicke des Stahlbandes und die Menge des abgeschiedenen Aluminiums in einem bestimmten Verhältnis stehen.

Anstelle der Verdampfung durch Elektronenbeschuß, kann man Metalle im Hochvakuum von $10^{-4}$ Torr an erhitzten Wolfram- oder Platindrähten verdampfen und den Metalldampf auf Werkstücken im Hochvakuum kondensieren lassen (vgl. Rev. Sci. Instr. 2, 189, 1931). Anstelle solcher Drähte kann man auch direkt oder indirekt beheizte Tiegel aus solchen Metallen verwenden.

Die Nachteile eines solchen Beschichtungsverfahrens mit nicht ionisiertem Metalldampf sind insbesondere darin zu sehen, daß die Elektronenstrahlverdampfung ebenso wie die wenig leistungsfähigen Verdampfungsverfahren mittels Heizdraht, Heiztiegel oder Glimmentladung ein Hochvakuum oder zumindest ein Teilvakuum voraussetzen, was die Eignung für eine Beschichtung von Stahlband erheblich einschränkt oder sehr aufwendig macht. So sind insbesondere für die Aufrechterhaltung eines Hochvakuums von $10^{-4}$ Torr umfangreiche Aufwendungen für die Bandschleusen beim Luft-zu-Luft-Betrieb und für Vakuumpumpen erforderlich. Schließlich kann bei den hier beschriebenen Verfahren in der Regel nur eine Bandseite beschichtet werden, nämlich die Unterseite des horizontal geführten Bandes.

Die US-PS 3 693 582 (3) enthält einen Vorschlag, wie man die Bedampfung von Stahlbändern durch Elektronenstrahlbedampfung im Hochvakuum gleichzeitig auf beiden Seiten durchführen kann. Hierbei werden zwei Verdampfungsquellen angebracht und das Band senkrecht zwischen beiden hindurchgeführt. Da hierbei die Ausbeute infolge geradliniger Ausbreitung der verdampften Metallatome nur einen Bruchteil dessen beträgt, was bei horizontaler Bandführung und einseitiger Bedampfung möglich wäre, sind zusätzlich beheizte Reflexionsschirme vorgesehen, die zum Zwecke der statischen Aufladung der Atome und anschließender Ablenkung derselben in Richtung auf das zu beschichtende Band die Abscheiderate, d. h. die Ausbeute erhöhen sollen. Wegen des geringen Wirkungsgrades einer solchen elektrostatischen Aufladung bleibt der Wirkungsgrad einer derartigen Anordnung hinter derjenigen bei horizontalem Bandlauf und einseitiger Abscheidung zurück. Alle anderen Nachteile der Bedampfung unter Hochvakuum bleiben voll erhalten.

Den wesentlichen Nachteil, der darin besteht, daß es unmöglich ist, ein Stahlband mit hoher Geschwindigkeit durch Schleusen in ein Hochvakuum einzuführen ohne den anschließenden Beschichtungsprozeß nachhaltig durch eingeschleppten Sauerstoff und Stickstoff zu stören, könnte man dadurch zu vermeiden versuchen, daß man das Hochvakuum-Verfahren durch ein Verfahren bei Normaldruck ersetzt. Hierzu gibt der Stand der Technik aber keine brauchbaren Vorschläge her. Es ist z. B. aus US-PS 4 223 047 (4) bekannt, ein mit hoher Geschwindigkeit laufendes Stahlband unter Normaldruck mit einer Ölschicht zu versehen, die elektrostatisch aus einem vorionisierten Ölnebel abgeschieden wird. Dieses Verfahren arbeitet mit Luft als Trägergas, was es für die Metallbeschichtung von vornherein ungeeignet macht, da es die Probleme mit Sauerstoff- und Stickstoff-Eintrag in den Arbeitsraum vervielfältigt. Zudem haftet der Vorionisation durch elektrostatische Felder der gleiche Nachteil eines geringen Wirkungsgrades an, wie er bereits weiter oben in Bezug auf die US-PS 3 693 582 (3) diskutiert wurde.

Ein weiteres Verfahren für Normaldruck ist in DE-PS 838 846 (1) beschrieben. Hierbei werden vorgewärmte Metalle, insbesondere Zinn, geschmolzen und mit Preßluft verspritzt, wobei die verspritzten Tropfen an einem negativen Pol aufgeladen und elektrostatisch auf das zu beschichtende Substrat gelenkt werden. Auch hier macht die vorhandene Luft die Anwendung auf sauerstoffaffine und stickstoffaffine Metalle unmöglich. Außerdem erzeugen Metalltropfen nicht immer geschlossene Überzüge, wie sie speziell bei der Beschichtung mit Aluminium u. ä. Metallen unbedingt anzustreben sind, soll es nicht zu lokalen Korrisionserscheinungen kommen.

Auch die US-PS 2 719 820 (2) gibt hier keine brauchbare Lehre. Hier wird in einem mehrstufigen sehr aufwendigen und störanfälligen Verfahren zunächst eine Metallschicht elektrolytisch auf ein schnell laufendes Band abgeschieden, auf welche eine zweite Metallschicht aufgespritzt wird, bei der das Spritzen in einem elektrostatischen Feld erfolgt, wobei die Tröpfchen elektrostatisch aufgeladen und auf das Substrat gelenkt werden. Zwar wird die Verwendung einer nicht oxydierenden Atmosphäre empfohlen, doch kann eine Gleichmäßigkeit der Überzüge auch bei diesem elektrostatisch unterstützten Spritzprozeß kaum gewährleistet werden. Das Patent beschränkt sich deshalb auch auf ausgesprochen dünnflüssige und niedrig schmelzende Metalle wie Blei, Zinn, Zink u. ä., bei denen die Schichtbildung durch Zusammenfließen der aufgespritzen Tröpfchen gefördert wird.

Es kann ferner die Metallverdampfung unter Wärmezufuhr durch einen Plasmabrenner unter Normaldruck durchgeführt werden, jedoch ist eine Abscheidung der nicht ionisierten Metallatome zur Erzielung einer gleichmäßigen Schicht hierbei nur über den Trägergasstrom steuerbar und daher für eine gleichmäßige Beschichtung großer Flächen nicht geeignet. Auch die Kopplung mit einer nachgeschalteten elektrostatischen Aufladung etwa entsprechend (3) würde wegen des geringen Wirkungsgrades einer solchen Aufladung zu keinem befriedigenden Ergebnis führen.

Es ist ferner bekannt, vgl. DE-OS 32 06 622 für die Beschichtung eines Substrates mit Metalldampf einen Lichtbogen zwischen einer Elektrode und einem Metallband zu erzeugen. Das Substrat wird dazu in den direkten Weg des Metalldampfes in der Umgebung des Lichtbogens eingebracht.

Aus der EU-PS 8634 ist ein Verfahren zum Auflagern einer Metall- oder Legierungsschicht auf ein elektrisch-leitendes Werkstück mittels einer Glimmentladung bekannt, wozu das Werkstück als die eine Elektrode eines elektrischen Feldes geschaltet ist, wobei das Trägergas und das Spendermedium vorher ionisiert werden und im ionisierten Zustand in das elektrische Feld überführt werden, dabei werden Metallionen durch Niederdruckentladung ($10^{-2}$ mm HG) erzeugt.

Bei einem weiteren bekannten Verfahren, vgl. DE-OS 23 46 738 wird ein Draht durch eine Stoßstromentladung verdampft und der Metalldampf durch Anlegen eines magnetischen und/oder elektrischen Feldes auf die zu beschichtende Oberfläche gerichtet.

Nachteilig bei den drei zuletzt genannten Verfahren ist, daß die Abscheidung nur dort erfolgen kann, wo das Plasma unmittelbar auf das zu beschichtende Substrat trifft. Die geometrische Plasmaausbildung muß daher jeweils den Abmessungen des zu beschichtenden Teils angepaßt werden. Andernfalls ist u. a. eine unkontrollierte Erwärmung des Substrats unvermeidlich und nachteilig.

Es wird ferner in vielen Fällen ein Niederdruckplasma vorgeschlagen. Bei einer Beschichtung von Stahlband muß jedoch jede Reaktion von Sauerstoff mit dem Metalldampf im Plasmazustand, der Stahlbandoberfläche und der aufgebrachten metallischen Beschichtung auf jeden Fall vermieden werden. Dies kann bei einem Niederdruckverfahren nicht realisiert werden, wenn das Stahlband kontinuierlich mit hoher Geschwindigkeit durch die Beschichtungskammer geführt wird.

Bei den zuletzt genannten Verfahren handelt es sich insgesamt um Verfahren zur Beschichtung einzelner Werkstücke, sie können damit zur Lösung der erfindungsgemäß gestellten Aufgabe nicht herangezogen werden.

Der Erfindung liegt die Aufgabe zugrunde, ein Verfahren der eingangs genannten Art so auszugestalten, daß auf ein schnell laufendes Stahlband kontinuierlich eine beidseitige hochwertige Beschichtung in einfacher Weise aufgebracht werden kann, wobei auch bei verhältnismäßig breiten Stahlbändern, bevorzugter Weise mit einer Breite von mehr als 1.000 mm, eine enge Schichtdickentoleranz sowohl über die Bandlänge als auch über die Bandbreite erzielt wird, und das Verfahren insgesamt einfach durchzuführen ist.

Der Erfindung liegt ferner die Aufgabe zugrunde, die bei einem
derartigen Beschichtungsverfahren zwingend notwendige Reinigung
der zu beschichtenden Stahlbandoberflächen von anhaftenden Öl-
oder Emulsionsrückständen in einfacher Weise und in das Beschichtungsverfahren integriert durchzuführen unter Vermeidung
der üblichen aufwendigen naßchemischen Reinigungsverfahren.

Nach der Erfindung wird die Aufgabe dadurch gelöst, daß ein
oder mehrere Metalle oder Metallegierungen in einem ersten
Schritt in einem thermischen Plasma aus nicht oxydierendem Gas
kontinuierlich verdampft und selbst in den hoch ionisierten Zustand des thermischen Plasmas überführt werden und in einem
zweiten Schritt bei einem gegenüber dem Außendruck um 100 Pa
bis 5.000 Pa erhöhten Druck die in diesem Plasma vorhandenen
Metallionen elektrostatisch auf der Oberfläche des Stahlbandes
abgeschieden werden, das Stahlband während des Beschichtens auf
einer gleichmäßigen Temperatur gehalten und bei einer Geschwindigkeit von 40 bis 600 m/min beschichtet wird.

Dabei werden die beiden Verfahrensschritte, nämlich Überführung
des Metalls oder der Metallegierung in den hochionisierten Zustand des thermischen Plasmas und das Abscheiden der in diesem
Plasma vorhandenen Metallionen örtlich getrennt nacheinander
durchgeführt.

Der erste Verfahrensschritt wird dabei mit Vorteil in der unteren Hälfte der Kammer durchgeführt und der zweite Verfahrensschritt im mittleren Bereich der Kammer. Auf diese Weise ist
eine örtliche Trennung der Überführung des Beschichtungsmetalls
in den hoch ionisierten Plasmazustand einerseits und der Abscheidung des Beschichtungsmetalls auf dem Stahlband andererseits erreicht, so daß auf diese Weise die Erwärmung des Stahlbandes gesteuert werden kann. Diese örtliche Trennung darf
allerdings nur soweit getrieben werden, daß sich im abkühlenden
und durch Ionenneutralisation rekombinierenden Plasma an der Abscheidestelle noch eine ausreichende Menge abscheidbarer Metallionen befindet. Die für eine Erzeugung festhaftender Beschichtungen notwendige Reinigung der Stahlbandoberflächen wird erfindungsgemäß dadurch erreicht, daß die Oberfläche des Stahlbandes im Rahmen des zweiten Verfahrensschritts in einem Verfahrensabschnitt vor der elektrostatischen Beschichtung einem heißen Plasma ausgesetzt und dadurch gereinigt wird.

Eine vorteilhafte Ausführungsform einer Einrichtung zum Herstellen eines metallischen Überzuges auf Stahlband nach der Erfindung ist dadurch gekennzeichnet, daß in einer weitgehend gasdicht ausgeführten Kammer mit mittig angeordneten Ein- und Ausführungsöffnungen für das zu beschichtende bzw. beschichtete Stahlband neben der Ausführungsöffnung zu beiden Seiten Gasleitungen in die Kammer geführt sind, die Gasleitungen innerhalb der Kammer mit Erzeugungseinrichtungen für aus Gas- und Metallionen bestehendes thermisches Plasma versehen sind, zwischen diesen Erzeugungseinrichtungen und Stahlband Abschirmplatten vorgesehen sind und im mittleren Bereich der Kammer mit Abstand von dem Stahlband an beiden Seiten elektrisch positiv geladene Abscheideplatten angeordnet sind.

Weitere vorteilhafte Ausführungsformen und Weiterbildungen des Verfahrens und der Einrichtung nach der Erfindung ergeben sich aus der folgenden Beschreibung sowie den Patentansprüchen.

Die Vorteile des erfindungsgemäßen Verfahrens und der Vorrichtung, durch die die Nachteile des Standes der Technik vermieden werden, sind darüber hinaus darin zu sehen, daß durch die elektrostatische Abscheidung der Metallionen die Schichtdicke gut gesteuert und der Bandbreite und Bandgeschwindigkeit angepaßt werden kann, durch die Aufrechterhaltung eines Überdruckes in der mit nicht oxidierendem Gas gefüllten Kammer die Oxidation des Metalldampfes auf einfache Weise vermieden wird, durch eine Steuerung der Mengenanteile verschiedener dem Plasma zugeführten Metalle bei gleichzeitiger Abscheidung Legierungen erzeugt werden können, die nach den Gleichgewichtszuständen nicht auf schmelzmetallurgischem Wege und in vielen Fällen aufgrund der Stellung in der elektrolytischen Spannungsreihe der Metalle auch nicht auf galvanotechnischem Wege hergestellt werden können, und daß schließlich durch die vorgeschlagene Trennung der Erzeugung von Ionen aus Metallen oder Metallegierungen als Bestandteil eines thermischen Plasmas in einem ersten Verfahrensschritt und Abscheidung der Metallionen durch ein elektrostatisches Feld in einem zweiten Verfahrensschritt die Erwärmung des zu beschichtenden Bandes optimal gesteuert werden kann.

Bei der Untersuchung des beschriebenen Verfahrens an einer Pilotanlage zeigte es sich, daß fest metallische Überzüge nur dann erzielt werden können, wenn jeglicher Sauerstoff ferngehalten wird. Bei Verwendung von Luft als Plasmagas wurde das behandelte Stahlband oxydiert. Auf den gebildeten Oxidschichten konnten dann keine metallischen Überzüge gebildet werden. Bei einem weitgehenden Fernhalten des Sauerstoffs durch Füllen der Behandlungskammer mit einem nichtoxydierenden Gas, wie Argon, bei einem Druck entsprechend dem der Außenluft konnte die Oxydation des Stahlbandes zwar soweit vermindert werden, daß metallische Überzüge abgeschieden wurden. Eine geringe Oxydation des Stahlbandes konnte durch diese Maßnahme jedoch immer noch nicht verhindert werden. Offensichtlich verhinderte diese Maßnahme den Zutritt von Luftsauerstoff an den Ein- und Austrittsstellen des Bandes nicht völlig. Die abgeschiedenen Überzüge waren in diesem Fall nicht festhaftend.

Überraschenderweise zeigte es sich jedoch, daß festhaftende Überzüge erzeugt werden können, wenn in der Behandlungskammer ein geringfügiger Überdruck des nichtoxydierenden Gases von mehr als 100 Pa gegenüber dem Außendruck aufrecht erhalten wird. Bei einem Pilotversuch wurde zum Beispiel in der Behandlungskammer ein gleichbleibender Überdruck von 110 Pa gegenüber dem Außendruck eingestellt. Unter diesen Bedingungen konnten durch Anwendung des vorgeschlagenen Verfahrens festhaftende metallische Überzüge auf Stahlband erzeugt werden.

Es zeigte sich jedoch auch, daß der Druck des nichtoxydierenden Gases in der Behandlungskammer nicht zu hoch eingestellt werden darf. Bei Überbrücken von mehr als 5.000 Pa wird nämlich die Plasmaflamme instabil und es treten lichtbogenähnliche elektrische Entladungen zwischen dem Stahlband 1 und den Abscheideplatten 8 auf, die Beschädigungen des Stahlbandes verursachen.

Weitere Untersuchungen an einer Pilotanlage zeigten, daß festhaftende metallische Überzüge auf Stahlbändern ohne Auftreten von elektrischen Überschlägen und daraus resultierender Beschädigung des Stahlbandes erzeugt werden können, wenn der Überdruck des nicht oxydierenden Gases im Bereiche 100 Pa bis 5.000 Pa liegt.

Bei durchgeführten Untersuchungen zeigte es sich ferner, daß festhaftende metallische Überzüge auch dann nicht erzeugt werden können, wenn die Oberfläche des Stahlbandes z. B. durch Fette oder Walzemulsionen verunreinigt ist.

Es stellte sich jedoch überraschenderweise heraus, daß diese Verunreinigungen beim erfindungsgemäßen Verfahren dadurch beseitigt werden können, daß das Stahlband kurzzeitig einem Plasmastrom direkt ausgesetzt wird. So konnten auf Stahlbänder, deren Oberfläche mit Walzemulsionen benetzt war, festhaftende Metallüberzüge erzeugt werden, wenn diese Stahlbänder im Rahmen des zweiten Verfahrensschritts vor der eigentlichen Beschichtung etwa 10 s lang einem thermischen Plasma ausgesetzt waren. Dieses Plasma kann entweder durch zusätzliche Plasma-Erzeugungseinrichtungen hergestellt werden, oder es kann als Teilstrom aus dem im ersten Vefahrensschritt erzeugten, aus Inertgas- und Metallionen bestehenden thermischen Plasma abgezweigt werden.

In den Zeichnungen sind bevorzugte Ausführungsbeispiele von Einrichtungen zum Herstellen hochwertiger metallischer Überzüge auf Stahlband dargestellt.

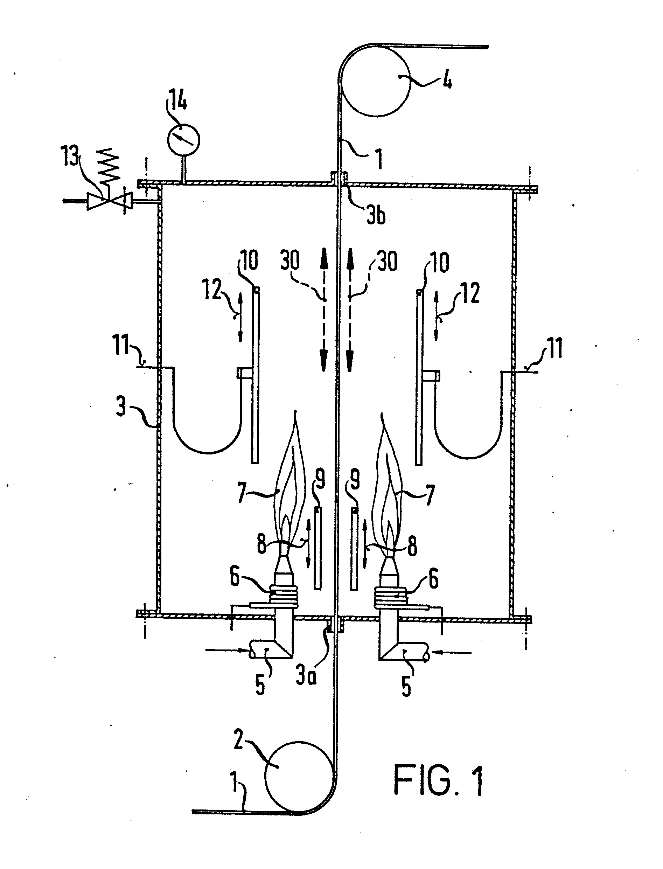

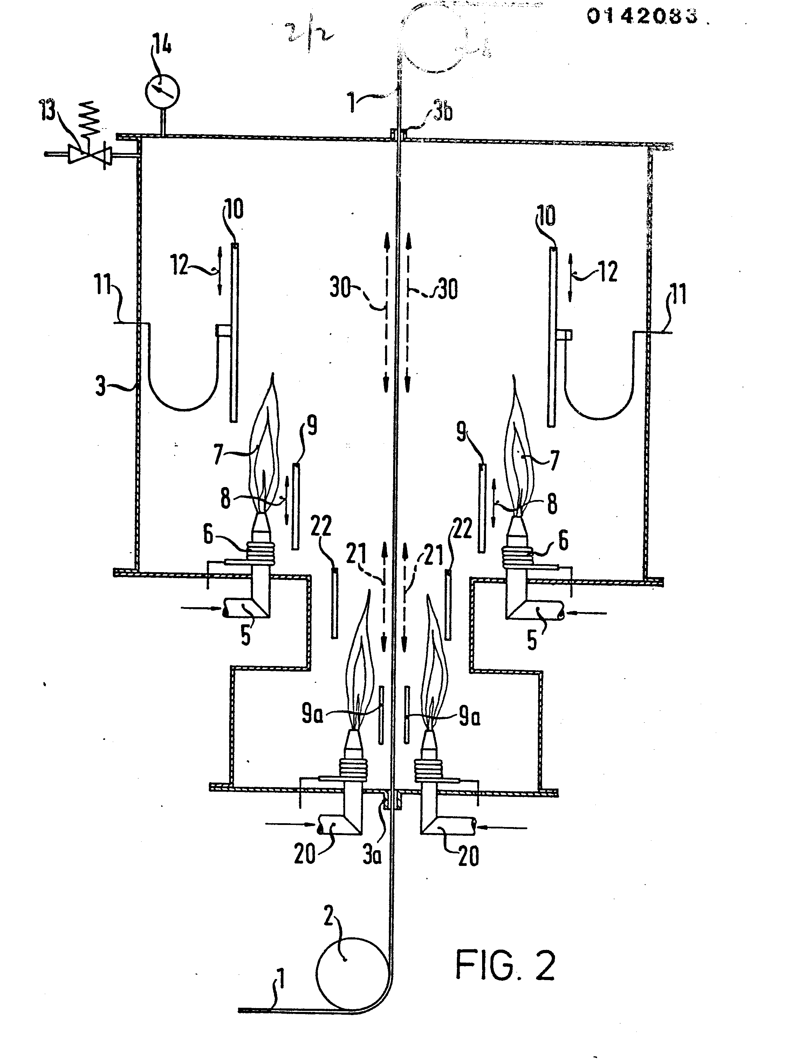

Dabei stellt Fig. 1 eine Einrichtung zur Beschichtung eines bereits gereinigten (z. B. blankgeglühten oder gebeizten) Stahlbands dar, während Fig. 2 im Rahmen des zweiten Verfahrensschritts eine Reinigung der Stahlbandoberfläche vor der Beschichtung mittels heißem thermischen Plasma umfaßt.

Im einzelnen zeigt Fig. 1 folgendes:

Das zu beschichtende Stahlband 1, z. B. kaltgewalztes Band, wird über eine Umlenkrolle 2 in eine durch eine Eintrittsöffnung 3 a weitgehend gasdicht ausgeführte Kammer 3 eingeführt, tritt nach der Beschichtung an der gegenüberliegenden Seite der Kammer 3 durch die Austrittsöffnung 3 b aus und wird über eine weitere Umlenkrolle 4 z. B. einem nicht dargestellten Haspel zugeführt und dort gewickelt.

Durch Leitungen 5, die zu beiden Seiten des in die Kammer 3 einzuführenden Stahlbandes 1 angeordnet sind, wird ein inertes und leicht reduzierendes, d. h. nicht oxidierendes Gas bei einem Überdruck von vorzugsweise etwa 500 Pa bis etwa 1.000 Pa gegenüber der Umgebung in die Kammer 3 eingeführt. Dieses nichtoxidierende Gas dient als Trägergas für die abzuscheidenden Metalle oder Metallegierungen und enthält diese in feinverteilter Form. Als Metalle oder Metallegierungen kommen bevorzugt infrage Aluminium, Zinn, Zink, Chrom, Nickel, Kupfer und deren Legierungen. Mittels einer induktiven oder kapazitiven Ankopplung eines hochfrequenten elektrischen Feldes 6 wird aus dem Gas ein thermisches Plasma 7 erzeugt, in welchem auch die Metalle oder Metallegierungen ionisiert werden und so einen Bestandteil des Plasmas bilden. In gleicher Weise kann das Plasma auch durch einen Lichtbogen erzeugt werden. Als Gas wird bevorzugt Argon oder ein Argon-Wasserstoff-Gemisch verwendet.

Zwischen dem Stahlband 1 und dem Plasma 7 sind in Richtung der Pfeile 8, d. h. in Bandlaufrichtung und gegen die Bandlaufrichtung verschiebbare Abschirmplatten 9 vorgesehen, mittels der eine unmittelbare Wärmeeinwirkung des Plasmas 7 auf das Stahlband 1 vermieden wird. Durch ein Verschieben der Abschirmplatten 9 kann diese Wärmeeinwirkung gesteuert werden, so daß das
Stahlband 1 auf einer gleichmäßigen Temperatur gehalten werden
kann.

Im mittleren Bereich der Kammer 3 sind mit Abstand von dem
Stahlband 1 an beiden Seiten Abscheideplatten 10 angeordnet,
die gegenüber dem Stahlband 1 elektrisch positiv geladen sind
und zwischen denen das Stahlband 1 hindurchgeführt wird. Die
elektrisch positiv geladenen Metallionen aus dem Plasma 7 bewegen sich daher auf das Stahlband 1 zu und werden auf dessen
Oberfläche im Bereich 30 abgeschieden.

Die elektrische Ladung der Abscheideplatten 10 wird mittels
eines nicht dargestellten Hochspannungsgleichstromgenerators
erreicht, der über elektrische Leitungen 11 an die Abscheideplatten 10 angeschlossen ist.

Eine Anpassung der bei unterschiedlicher Dicke des Stahlbandes,
unterschiedlichem Beschichtungsmetall, gewünschter Beschichtungsdicke und einer gewünschten oder noch zulässigen Erhitzung
und Erhitzungsrate des Stahlbandes, jeweils erforderlichen örtlichen Trennung der Verdampfung des Beschichtungsmetalles und
dessen Abscheidung auf der Oberfläche wird dadurch erreicht,
daß die Abscheideplatten 10 in Richtung der Pfeile 12 verschiebbar sind. Der Abscheideort 30 auf dem Stahlband 1 in Bezug zum eigentlichen Plasma 7 kann damit optimal verändert werden.

Das rekombinierte, elektrisch neutrale Inertgas verläßt die
Kammer 3 durch ein regelbares Gasauslaßventil 13. Nahe der
Stelle des Gasaustritts bzw. des Ventils 13 ist ein Druckmeßgerät 14 vorgesehen; mittels des im Druckmeßgerät 14 gemessenen
Druckes des Gases innerhalb der Kammer 3 wird die Öffnung bzw.
Schließung des Gasauslaßventils 13 geregelt, und zwar so, daß in der Kammer 3 ein vorgegebener Überdruck des nicht oxidierenden Gases aufrechterhalten wird. Da nicht oxidierende Gase bzw.
Schutzgase sehr teuer sind, wird das Gas nach dem Verlassen der
Kammer 3, gegebenenfalls nach einer Wiederaufbereitung durch
Entfernen etwa aufgenommenen Sauerstoffs, in die Gasleitungen 5
zur Wiederverwendung als Plasmabrenngas eingeführt.

In Fig. 2 gelten die gleichen Bezugsziffern wie in Fig. 1, jedoch sind zusätzlich Plasmageneratoren 20 dargestellt, durch
welche thermisches Plasma erzeugt wird. Dieses trifft die Oberfläche des Stahlbandes im Bereich 21 und reinigt diese vor dem
Beschichten wirksam und gründlich. Zusätzliche elektrostatische
Ablenkplatten 22 können dabei den zur Reinigung bestimmten
Plasmastrom gleichmäßig über die Bandbreite verteilen. Die
Platten 22 können mit den Abschirmplatten 8 identisch sein. Die
erfindungsgemäße Reinigung ist aber auch mit der in Fig. 1 gezeichneten Einrichtung möglich, d. h. ohne zusätzliche Plasmageneratoren 20, wenn durch die elektrisch positiv geladenen Abscheideplatten 10 eine selektive Ablenkung von Inertgasplasma
so erfolgt, daß dieses vor den Metallionen die Stahlbandoberfläche erreicht.

| | |
|---|---|
| 1 | Stahlband |
| 2, 4 | Umlenkrollen |
| 3 | Kammer |
| 3 a, 3 b | Ein-, Ausführungsöffnungen (der Kammer 3) |
| 5 | Gasleitungen |
| 6 | hochfrequentes elektrisches Feld |
| 7 | Plasma |
| 8 | Pfeile (an Platten 9) |
| 9 | Abschirmplatten |
| 9 a | Abschirmplatten |
| 10 | Abscheideplatten |
| 11 | elektrische Leitungen (an Abscheideplatten 10) |
| 12 | Pfeile (an Abscheideplatten 10) |
| 13 | Gasauslaßventil |
| 14 | Druckmeßgerät |
| 20 | Plasmagenerator |
| 21 | Reinigungszone (Pfeile) verschiebbar |
| 22 | Ablenkplatten |
| 30 | Abscheidebereich (Pfeile) verschiebbar |

0142083

Hoesch Aktiengesellschaft,
Eberhardstraße 12, 4600 Dortmund 1

<u>Patentansprüche</u>

1. Verfahren zum kontinuierlichen Herstellen hochwertiger metallischer Überzüge auf Stahlband unter Verwendung eines
   Plasmas, dadurch gekennzeichnet, daß ein oder mehrere Metalle oder Metallegierungen in einem ersten Schritt in
   einem thermischen Plasma aus nichtoxidierendem Gas kontinuierlich verdampft und selbst in den hoch ionisierten Zustand des thermischen Plasmas überführt werden und in einem
   zweiten Schritt bei einem gegenüber dem Außendruck um
   100 Pa bis 5.000 Pa erhöhten Druck die in diesem Plasma
   vorhandenen Metallionen elektrostatisch auf der Oberfläche
   des Stahlbandes abgeschieden werden, daß Stahlband während
   des Beschichtens auf einer gleichmäßigen Temperatur gehalten und bei einer Geschwindigkeit von 40 m/min bis
   600 m/min beschichtet wird, wobei der erste Schritt, nämlich die Überführung des Metalls oder der Metallegierung in
   den hoch ionisierten Zustand und der zweite Schritt, nämlich das Abscheiden der Metallionen, örtlich getrennt nacheinander durchgeführt werden.

2. Verfahren nach Anspruch 1, dadurch gekennzeichnet, daß das
   Plasma aus nichtoxidierendem Gas und Beschichtungsmetall
   oder Beschichtungsmetallegierung durch induktive Ankopplung
   erzeugt wird.

3. Verfahren nach Anspruch 1, dadurch gekennzeichnet, daß das
   Plasma aus nichtoxidierendem Gas und Beschichtungsmetall
   oder Beschichtungsmetallegierung durch kapazitive Ankopplung erzeugt wird.

4. Verfahren nach Anspruch 1, dadurch gekennzeichnet, daß das Plasma aus nichtoxidierendem Gas und Beschichtungsmetall oder Beschichtungsmetallegierung durch einen elektrischen Lichtbogen erzeugt wird.

5. Verfahren nach den Ansprüchen 1 bis 4, dadurch gekennzeichnet, daß die Oberfläche des Stahlbandes im Rahmen des zweiten Verfahrensschrittes in einem Verfahrensabschnitt vor der elektrostatischen Beschichtung einem heißen Plasma ausgesetzt und dadurch gereinigt wird.

6. Verfahren nach den Ansprüchen 1 bis 5, dadurch gekennzeichnet, daß das Stahlband bei einer Geschwindigkeit von 60 m/min bis 360 m/min beschichtet wird.

7. Verfahren nach den Ansprüchen 1 bis 6, dadurch gekennzeichnet, daß das verwendete nicht oxidierende Gas, gegebenenfalls nach einer Wiederaufbereitung zur Entfernung von etwa aufgenommenem Sauerstoff, wieder verwendet wird.

8. Einrichtung zum Herstellen eines metallischen Überzugs auf Stahlband nach den Ansprüchen 1 bis 7, dadurch gekennzeichnet, daß in einer weitgehend gasdicht ausgeführten Kammer (3) mit mittig angeordneten Ein- und Ausführungsöffnungen (3 a, 3 b) für das zu beschichtende bzw. beschichtete Stahlband (1) neben der Einführungsöffnung (3 a) zu beiden Seiten Gasleitungen (5) in die Kammer (3) geführt sind, die Gasleitungen (5) innerhab der Kammer (3) mit Erzeugungseinrichtungen für aus Gas- und Metall-Ionen bestehendes thermisches Plasma versehen sind, zwischen diesen Erzeugungseinrichtungen und Stahlband (1) Abschirmplatten (9) vorgesehen sind und im mittleren Bereich der Kammer (3) mit Abstand von dem Stahlband (1) an beiden Seiten elekrisch positiv geladene Abscheideplatten (10) angeordnet sind.

0142083

9. Einrichtung nach Anspruch 8, dadurch gekennzeichnet, daß jeweils vor der Einlaß- und Auslaßöffnung der Kammer (3) eine Umlenkrolle (2, 4) angeordnet ist.

10. Einrichtung nach den Ansprüchen 8 und 9, dadurch gekennzeichnet, daß im oberen Teil der Kammer (3) ein und durch ein Druckmeßgerät geregeltes Gasauslaßventil (13) vorgesehen ist.

11. Einrichtung nach Anspruch 8, dadurch gekennzeichnet, daß die Abscheideplatten (10) an einen Hochspannungsgleichstromgenerator angeschlossen sind.

12. Einrichtung nach den Ansprüchen 8 bis 11, dadurch gekennzeichnet, daß die Abschirmplatten (9) und die Abscheideplatten (10) parallel zu dem Stahlband (1) verschiebbar ausgebildet sind.

13. Einrichtung nach den Ansprüchen 8 bis 12, dadurch gekennzeichnet, daß zusätzliche Plasmageneratoren 20 zur Erzeugung eins auf die Stahlbandoberfläche treffenden Plasmastroms angeordnet sind.

14. Einrichtung nach den Ansprüchen 8 bis 13, dadurch gekennzeichnet, daß zusätzliche elektrostatische Ablenkplatten 22 vorhanden sind, welche Stärke und Richtung des der Reinigung dienenden Plasmastroms steuern.

FIG. 1

0142083.

FIG. 2